Europäisches Patentamt

European Patent Office

Office européen des brevets

(11) Veröffentlichungsnummer: **0 255 659 B1**

# (12) EUROPÄISCHE PATENTSCHRIFT

(45) Veröffentlichungstag der Patentschrift: **13.11.91**

(51) Int. Cl.⁵: **H02H 3/42, G01R 31/06**

(21) Anmeldenummer: **87110612.6**

(22) Anmeldetag: **22.07.87**

(54) **Elektronischer Überstromauslöser.**

(30) Priorität: **04.08.86 DE 3626398**

(43) Veröffentlichungstag der Anmeldung:
**10.02.88 Patentblatt 88/06**

(45) Bekanntmachung des Hinweises auf die
Patenterteilung:
**13.11.91 Patentblatt 91/46**

(84) Benannte Vertragsstaaten:
**AT BE CH DE FR GB IT LI NL SE**

(56) Entgegenhaltungen:
**DE-A- 2 539 451**
**DE-A- 2 747 575**
**DE-B- 1 763 527**
**US-A- 4 100 587**

(73) Patentinhaber: **SIEMENS AKTIENGESELL-
SCHAFT**
**Wittelsbacherplatz 2**
**W-8000 München 2(DE)**

(72) Erfinder: **Maier, Reinhard, Dr.**
**Anna-Hermann-Strasse 54**
**W-8522 Herzogenaurach(DE)**
Erfinder: **Goth, Kurt**
**Westl. Waldringstrasse 24c**
**W-8510 Fürth(DE)**

## Beschreibung

Die Erfindung bezieht sich auf einen elektronischen Überstromauslöser für mehrphasige Leistungsschalter mit einer Stromerfassung und einer Kurzschlußstromauswertung, einer Vergleichsschaltung sowie einem Auslösebefehlsgeber.

Bei einem bekannten elektronischen Überstromauslöser der obengenannten Art (Siemens Energie-Technik 2 (1980) Heft 12 Seiten 499 - 502) ist zwar eine Erfassung von Überströmen und Kurzschlüssen und damit über den Auslösebefehlsgeber ein Abschalten des Leistungsschalters möglich. Der Erfindung liegt die Aufgabe zugrunde, diesen Überstromauslöser dahingehend zu ertüchtigen, daß auch Windungsschlüsse in Motoren erfaßt werden und zur Auslösung des Leistungsschalters führen können. Dies wird auf einfache Weise dadurch erreicht, daß eine Einrichtung zur Spannungserfassung und zur Multiplikation der jeweils einer Phase zugeordneten Strom- und Spannungsmomentanwerte, sowie zur Summation der solchermaßen gebildeten Momentanleistungen der einzelnen Phasen vorgesehen ist, deren Ausgang einer Vergleichsschaltung zugeführt ist, welche bei einer vorbestimmten Abweichung mit dem Auslösebefehlsgeber in Wirkverbindung steht, und daß der Summation in jeder Phase eine Filteranordnung als Bandfilter vorgeschaltet ist, dessen Durchlaßfrequenz der doppelten Netzfrequenz entspricht.

Bei Rückleistungsrelais ist es an sich bekannt, (US-PS 4 100 587), die Momentanleistungswerte zu summieren. Die Summe der Momentanleistungen wird einem Tiefpaßfilter zugeführt, in dem die Wechselanteile ausgefiltert werden, so daß sich die Wirkleistungen der drei Phasen addieren. Das Ergebnis wird einem Vergleicher zugeführt, in dem die eingegebenen Werte mit einem fest eingestellten Vergleichswert verglichen werden. Beim Gegenstand der Erfindung hingegen werden die Wirkanteile der Momentanleistungen vor der Summierung herausgefiltert, so daß die Wechselanteile als Summe zur Bildung eines Auslösekriteriums für aufgetretene Windungsschlüsse zur Verfügung stehen. Im eingeschwungenen Zustand ist das aus der Multiplizierschaltung abgegebene Signal eine gegenüber der Nulllinie um die Wirkleistung verschobene Schwingung mit doppelter Netzfrequenz. Beim Einschalten Lastwechsel/Kurzschluß, also bei allen Zustandsänderungen, werden im Signal auch andere Frequenzen als Null und doppelter Netzfrequenz auftreten. Das Vorsehen einer Filteranordnung sorgt dafür, daß die erfindungsgemäße Schaltung in ihrem Arbeitsbereich angesteuert werden kann. Sind in den einzelnen Phasensträngen zwischen Filteranordnung und Gleichrichterschaltung Symmetrieglieder zwischengeschaltet, so können Unterschiede in den Phasenleistungen der gesunden Maschine ausgeglichen werden. Vorteilhaft ist es weiterhin, wenn die Symmetrieglieder einspeisungsseitig vorhandene Unsymmetrien berücksichtigen. Das Summierglied addiert die einzelnen Phasenmomentanleistungen und ermöglicht so die Detektion von Motorfehlern. Da beim Einschalten des Motors die Kontakte des Schalters nicht völlig gleichzeitig schließen, können hier gegebenenfalls Fehlimpulse entstehen. Um dies zu vermeiden ist es vorteilhaft, wenn der Schmitt-Triggerschaltung eine Verzögerungsschaltung und ein UND-Glied nachgeschaltet ist, dessen zweiter UND-Eingang am Ausgang des Schmitt-Triggers liegt. Dies bewirkt, daß die Schaltung erst ca. 1 Sekunde nach dem Einschalten des Motors wirksam wird. Während dieser Zeit ist jedoch die Strompegelüberwachung wirksam. Diese Verzögerung scheint akzeptabel, da bei einem kompletten Motorschutz der Motor vor dem Einschalten bereits auf das Vorhandensein eines Windungsschlusses geprüft werden kann. Eine einfache Ausführung für die Kurzschlußstromüberwachung ergibt sich, wenn die Kurzschlüsse von einem Integrationsverstärker als Tiefpaß, dem eine Gleichrichterschaltung, ein Schmitt-Trigger, sowie ein mit dem Auslösebefehlsgeber in Verbindung stehendes Flip-Flop nachgeschaltet sind, verarbeitet werden.

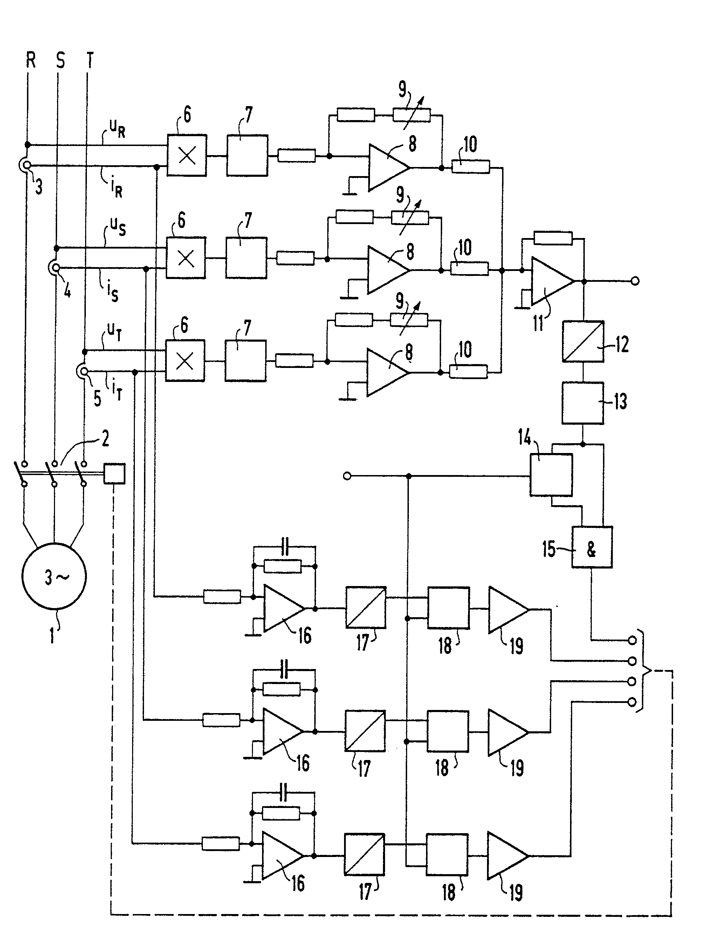

Anhand der Zeichnung wird ein Ausführungsbeispiel gemäß der Erfindung beschrieben.

Die in der Zeichnung dargestellte Schaltung für den elektronischen Überstromauslöser dient zur Abschaltung eines Motors 1, der über das Schaltgerät 2 an das Dreiphasennetz RST anlegbar ist. Zur Erfassung des fließenden Stromes dienen Stromwandler 3, 4, 5. Der hierdurch erfaßte Strom IR, IS, IT sowie die Spannungen UR, US, UT liegen an Multiplizierschaltungen 6, in denen den momentanen Leistungen der einzelnen Phasen entsprechende Signale gebildet werden. Im eingeschwungenen Zustand sind diese Signale eine gegenüber der Nulllinie um die Wirkleistung verschobene Schwingung mit doppelter Netzfrequenz. Beim Einschalten Lastwechsel / Kurzschluß, also bei allen Zustandsänderungen, werden im Signal auch andere Frequenzen als Null und doppelte Netzfrequenz auftreten. Bei Zustandsänderungen kann der Anteil der Transienten so groß werden, daß die nachfolgende Schaltung nicht mehr in ihrem Arbeitsbereich angesteuert wird und somit funktionslos ist. Daher werden diese Signale auf ein aktives Bandfilter vierter Ordnung 7, dessen Mittenfrequenz doppelte Netzfrequenz beträgt, geführt. Die diesen Filtern nachgeschalteten Symmetrieglieder 8 sind proportional rückgekoppelte Operationsverstärker. Durch die Potentiometer 9, die im Rückkopplungszweig liegen, können die Unterschiede in den Phasenleistungen der gesunden Maschine und Netzunsymmetrien ausgeglichen werden. Die Summation der Einzelleistungen erfolgt über Widerstände 10, deren Summensignal an einem weiteren Operationsverstärker 11 liegt. Am Ausgang des Operationsverstärkers 11 kann die Meßausgangsspannung abgenommen werden. Über einen nachgeschalteten Idealgleichrichter 12 wird der Mittelwert des Signals gebildet, und in einer Schmitt-Triggerschaltung 13 wird eine Pegelüberschreitung detektiert. Bei Messungen mit durch Anzapfen an den Wicklungen hervorgerufenen Windungsschlüssen hat sich gezeigt, daß die Amplituden von Strömen und Spannungen auch bei mehrere Windungen umfassenden Windungsschlüssen sehr geringe Unterschiede aufweisen, sich die Phasenverschiebungen zwischen Strömen und Spannungen jedoch stark ändern. Unter diesen Voraussetzungen läßt sich berechnen, daß das Ausgangssignal der Schaltung proportional 2UI sin ($\Delta\phi$ /2) ist, wobei $\Delta\phi$ der Phasenunterschied der Wicklung mit Windungsschluß zu den Wicklungen ohne Windungsschluß ist. Die Auswerteschaltung ist also stark phasenempfindlich. Diese Phasenempfindlichkeit ist gerade bei Windungsschlüssen, deren Ströme im Nennstrombereich liegen, notwendig. Das Auswerteverfahren sollte möglichst nur einen Windungsschluß zur Anzeige bringen. Alle normalen Betriebszustände sollen dabei unberücksichtigt bleiben. Ein Lastwechsel von Leerlauf auf Vollast ruft keine wesentlichen Änderungen des Summen-Signales hervor, obwohl die Momentanleistungen der einzelnen Phasen wesentlich größer werden. Beim Einschalten des Motors ist dies jedoch nicht der Fall. Dies rührt daher, daß die Kontakte des Schalters nicht völlig gleichzeitig schließen und das transiente Verhalten der drei Phasenwicklungen nicht identisch ist. Das vom Schmitt-Trigger 13 ausgehende Signal wird daher auf eine Verzögerungsschaltung 14 geführt, dessen Ausgang an einem UND-Glied 15 angeschlossen ist. Der zweite Eingang des UND-Gliedes ist mit dem Ausgang der Schmitt-Triggerschaltung 13 verbunden. Vom UND-Glied 15 geht, wenn beide Bedingungen erfüllt sind, das Auslösesignal zum Schaltgerät 2. Zur Erfassung von Kurzschlüssen, wie bekannt, dienen mit den Stromwandlern 3 bis 5 in Verbindung stehende Integrationsverstärker 16 als Tiefpaß, die über Gleichrichter 17 mit einer Schmitt-Trigger- und Flip-Flop-Schaltung 18 verbunden sind, Operationsverstärker 19 beaufschlagen. Der Ausgang der Operationsverstärker 19 führt wiederum zur Auslösung des Schaltgerätes 2.

Beim Auftreten eines Windungsschlusses hat das Ausgangssignal höchstens 10 ms später seinen endgültigen Wert erreicht. Begründet ist diese hohe Geschwindigkeit in dem Fehlen von z.B. integrierenden Elementen, wie sie für Effektivwertbestimmung oder ähnliches verwendet werden. Das einzige verzögerte Element in der Windungsschlußsignalbildung ist der Bandpaß 7, der mit einer Verzögerung von 10 ms der Zustandsänderung folgt.

## Patentansprüche

1. Mehrphasiger, elektronischer Überstromauslöser mit einer Stromerfassung (3,4,5) und einer Kurzschlußstromauswertung (16-19), einer Vergleichsschaltung (13) sowie einem Auslösebefehlsgeber, **dadurch gekennzeichnet,** daß eine Einrichtung zur Spannungserfassung und zur Multiplikation (6) der jeweils einer Phase (R,S,T) zugeordneten Strom-($i_R$,$i_S$,$i_T$) und Spannungsmomentanwerte ($u_R$,$u_S$,$u_T$), sowie zur Summation (11) der solchermaßen gebildeten Momentanleistungen der einzelnen Phasen vorgesehen ist, deren Ausgang der Vergleichschaltung (13) zugeführt ist, welche bei einer vorbestimmten Abweichung mit dem Auslösebefehlsgeber in Wirkverbindung steht, und daß der Summation (11) in jeder Phase (R,S,T) eine Filteranordnung (7) als Bandfilter vorgeschaltet ist, dessen Durchlaßfrequenz der doppelten Netzfrequenz entspricht.

2. Überstromauslöser nach Anspruch 1, **dadurch gekennzeichnet,** daß in den einzelnen Phasensträngen zwischen Filteranordnung (7) und Gleichrichterschaltung (12) Symmetrieglieder (8) zwischengeschaltet sind.

3. Überstromauslöser nach Anspruch 2, **dadurch gekennzeichnet,** daß die Symmetrieglieder (8) einspeisungsseitig vorhandene Unsymmetrien berücksichtigen.

4. Überstromauslöser nach Anspruch 1, 2 oder 3, **dadurch gekennzeichnet,** daß die Vergleichsschaltung eine Schmitt-Triggerschaltung (13) aufweist und daß der Schmitt-Triggerschaltung (13) eine Verzögerungsschaltung (14) und ein UND-Glied (15) nachgeschaltet ist, dessen zweiter UND-Eingang am Ausgang des Schmitt-Triggers (13) liegt.

5. Überstromauslöser nach Anspruch 1, **dadurch gekennzeichnet,** daß die Kurzschlüsse von einem Integrationsverstärker (16) als Tiefpaß, dem eine Gleichrichterschaltung (17), ein Schmitt-Trigger (18), sowie ein mit dem Auslösebefehlsgeber in Verbindung stehendes Flip-Flop (18) nachgeschaltet sind, verarbeitet werden.

## Claims

1. Multi-phase electronic overcurrent tripping device having a current detection means (3, 4, 5) and a short-circuit current evaluation means (16-19) of a comparison circuit (13) as well as a tripping control station, characterized in that a device is provided for the voltage detection and for the multiplication (6) of the current instantaneous values ($i_R$, $i_S$, $i_T$) and voltage instantaneous values ($U_R$, $U_S$, $U_T$), each being associated with a phase (R, S, T), as well as for the summation (11) of the instantaneous powers, formed in this way, of the individual phases, the output of which is supplied to the comparison circuit (13), which is in operative connection with the tripping control station at a predetermined deviation, and in that in each phase (R, S, T) there is connected in front of the summation means (11) a filter arrangement (7) as a band filter, the transmission frequency of which corresponds to double the network frequency.

2. Overcurrent tripping device according to claim 1, characterized in that balancing elements (8) are inserted into the individual phase conductors between filter arrangement (7) and rectifier circuit (12).

3. Overcurrent tripping device according to claim 2, characterized in that the balancing elements (8) take into consideration asymmetries present on the feed side.

4. Overcurrent tripping device according to claim 1, 2 or 3, characterized in that the comparison circuit has a Schmitt trigger circuit (13) and in that there is connected after the Schmitt trigger circuit (13) a delay circuit (14) and an AND-element (15), the second AND-input of which is connected to the output of the Schmitt trigger (13).

5. Overcurrent tripping device according to claim 1, characterized in that the short circuits are processed by an integrating amplifier (16) as a low-pass filter, with which there is connected in series a rectifier circuit (17), a Schmitt trigger (18), as well as a flip-flop (18) connected to the tripping control station.

**Revendications**

1. Déclencheur électronique polyphasé à surintensité comprenant une unité (3,4,5) de détection du courant et une unité (16-19) d'évaluation du courant de court-circuit, un circuit comparateur (13) ainsi qu'un transmetteur d'ordres de déclenchement, caractérisé par le fait qu'il est prévu un dispositif (6) de détection de la tension et de multiplication des valeurs instantanées du courant ($i_R$,$i_S$,$i_T$) et des valeurs instantanées de la tension ($U_R$, $U_S$, $U_T$), associées respectivement à une phase (R,S,T), et de sommation (11) des puissances instantanées, formées de cette manière, des différentes phases, et dont la sortie est raccordée au circuit comparateur (13) qui, dans le cas d'un écart prédéterminé, est raccordé selon une liaison active au transmetteur d'instructions de déclenchement, et que pour la sommation (11) dans chaque phase (R,S,T) est branché, en amont, un dispositif formant filtre (7) réalisé sous la forme d'un filtre passe-bande dont la fréquence passante correspond au double de la fréquence du secteur.

2. Déclencheur à surintensité suivant la revendication 1, caractérisé par le fait que des circuits de symétrie (8) sont intercalés dans les différentes phases entre le dispositif formant filtre (16) et le circuit redresseur (12).

3. Déclencheur à surintensité suivant la revendication 2, caractérisé par le fait que les circuits de symétrie (8) prennent en compte des dissymétries présentes sur le côté alimentation.

4. Déclencheur à surintensité suivant la revendication 1, 2 ou 3, caractérisé par le fait que le circuit comparateur possède un circuit déclencheur de Schmitt (13), en aval duquel sont branchés un circuit de retardement (14) et un circuit ET (15), dont la seconde entrée ET est raccordée à la sortie du déclencheur de Schmitt (13).

5. Déclencheur à surintensité suivant la revendication 1, caractérisé par le fait que les courts-circuits sont traités par un amplificateur d'intégration (16) formant filtre passe-bas, en aval duquel sont branchés un circuit redresseur (17), un déclencheur de Schmitt (18) ainsi qu'une bascule bistable (18) raccordée au transmetteur d'impulsions de déclenchement.